**Europäisches Patentamt**

**European Patent Office**

**Office européen des brevets**

(19)

(11) Veröffentlichungsnummer: **0 160 294**
**B1**

(12) ## EUROPÄISCHE PATENTSCHRIFT

(45) Veröffentlichungstag der Patentschrift:
**12.10.88**

(21) Anmeldenummer: **85105222.5**

(22) Anmeldetag: **29.04.85**

(51) Int. Cl.⁴: **C 01 B 33/02,** C 30 B 29/06,
C 30 B 15/00

(54) Verfahren zum Abtrennen von festen Reaktionsprodukten aus im Lichtbogenofen erzeugtem Silizium.

(30) Priorität: **04.05.84 DE 3416543**

(43) Veröffentlichungstag der Anmeldung:
**06.11.85 Patentblatt 85/45**

(45) Bekanntmachung des Hinweises auf die Patenterteilung:
**12.10.88 Patentblatt 88/41**

(84) Benannte Vertragsstaaten:
**DE FR GB IT**

(56) Entgegenhaltungen:
GB-A-2 046 232

**CHEMICAL ABSTRACTS, Band 59, Nr. 8, 14.
Oktober 1963, Spalte 8380a, Columbus, Ohio, US; &
JP - C - 62 15 006 (TOHO DENKA CO.) 25-09-1962**

(73) Patentinhaber: **Siemens Aktiengesellschaft Berlin
und München, Wittelsbacherplatz 2, D-8000
München 2 (DE)**

(72) Erfinder: **Aulich, Hubert, Dr., Schwarzstrasse 3,
D-8000 München 80 (DE)**
Erfinder: **Schulze, Friedrich- Wilhelm, Dr., Am
Lochfeld 12, D-8080 Eching (DE)**

## Beschreibung

Die Erfindung betrifft ein Verfahren zum Abtrennen von festen Reaktionsprodukten, wie $SiO_2$ und SiC, aus im Lichtbogenofen bei der Reduktion von $SiO_2$ und Kohlenstoff erzeugtem schmelzflüssigem Silizium, welches vorzugsweise als Ausgangsmaterial zur Herstellung von Solarzellen verwendet wird.

Zur wirtschaftlichen Nutzung der Sonnenenergie mit Solarzellen aus kristallinem Silizium müssen die Kosten für die Herstellung der Ausgangsmaterialien deutlich gesenkt werden. Das bekannteste und heute am kostengünstigsten arbeitende Verfahren zur Herstellung von Silizium ist die carbothermische Reduktion von Quarz im Lichtbogenofen. Ein solches Verfahren ist beispielsweise aus dem Buch "Silizium als Halbleiter" von R. Rost, Verlag Berliner Union Stuttgart, (1966), auf den Seiten 18/19 zu entnehmen. Aufgrund der stark verunreinigten Ausgangsmaterialien, wie Quarz, Petrolkoks, Holzkohle, Kohle, die bei diesen Verfahren eingesetzt werden, besitzt das gewonnene Silizium nur eine Reinheit von 96 bis 98,5 % und ist somit für die Herstellung von Solarzellen ungeeignet.

Aus der US-A-4 247 528 ist ein Verfahren zur Herstellung von Solarsilizium im Lichtbogenofen bekannt, bei dem hochreine Ausgangssubstanzen ($SiO_2$ und Ruß) unter hochreinen Bedingungen verarbeitet werden. Dadurch wird der Bor- und Phosphorgehalt und der Gehalt an Schwermetallen gesenkt und ein Reinheitsgrad von 99,9 % erreicht; in der Schmelze sind jedoch noch Verunreinigungen in Form von festen Reaktionsprodukten (nicht reduzierter Quarz, nicht reagierte Kohle und Siliziumcarbid-Teilchen) enthalten, die eine Weiterverarbeitung zu Siliziumkristallen erschweren. Bewährt hat sich hier ein zweimaliger Czochralski-Ziehprozeß, durch den sämtliche Teilchen entfernt werden. Die aus diesem Material hergestellten Solarzellen weisen Wirkungsgrade größer 10 % auf. Die zusätzlichen Prozeßschritte des Kristallziehens sind aber teuer und aufwendig.

Aufgabe der Erfindung ist es daher, ein Verfahren anzugeben, welches diesen Prozeß vereinfacht; insbesondere soll es möglich sein, das durch carbothermische Reduktion gewonnene Silizium sofort, das heißt ohne zusätzliche Kristallziehprozesse, der Herstellung von Siliziumkörpern für Solarzellen zuzuführen.

Diese Aufgabe wird durch ein Verfahren der eingangs genannten Art dadurch gelöst, daß das schmelzflüssige Silizium nach einer sogenannten "Haltephase" bei einer Temperatur im Bereich oberhalb des Schmelzpunktes von Silizium durch eine beheizte, aus dem Verbundwerkstoff SiC/Si bestehende Schicht filtriert, in hochreinen Graphitkokillen aufgefangen und einer gerichteten Erstarrung unterworfen wird. Dabei liegt es im Rahmen der Erfindung, daß für die Filtration ein Graphittiegel verwendet wird, dessen Boden aus einer Platte aus SiC/Si besteht. Der Gehalt an SiC wird dabei so eingestellt, daß bei der Filtration "Kanäle" mit einem Durchmesser kleiner 3 μm entstehen.

Formkörper, zum Beispiel Tiegel, Platten usw. aus dem Verbundwerkstoff SiC/Si werden industriell durch Eintauchen poröser Kohlenstoff-Vorformen in eine Siliziumschmelze hergestellt. Dabei wird eine große Menge des Kohlenstoffs in SiC umgewandelt; die Poren sind nach dem Entfernen der Vorform aus der Schmelze mit Silizium gefüllt. Das Verhältnis SiC : Si sowie die Porenverteilung kann durch die Wahl der Kohlenstoff-Vorform und die Reaktionsbedingungen mit der Siliziumschmelze in weiten Grenzen eingestellt werden.

Anstelle der SiC/Si-Platte kann aber gemäß einem anderen Ausführungsbeispiel nach der Lehre der Erfindung ein aus SiC-Körnern bestehendes Filterbett verwendet werden, wobei die SiC-Korngröße in Flußrichtung des schmelzflüssigen Siliziums zunimmt.

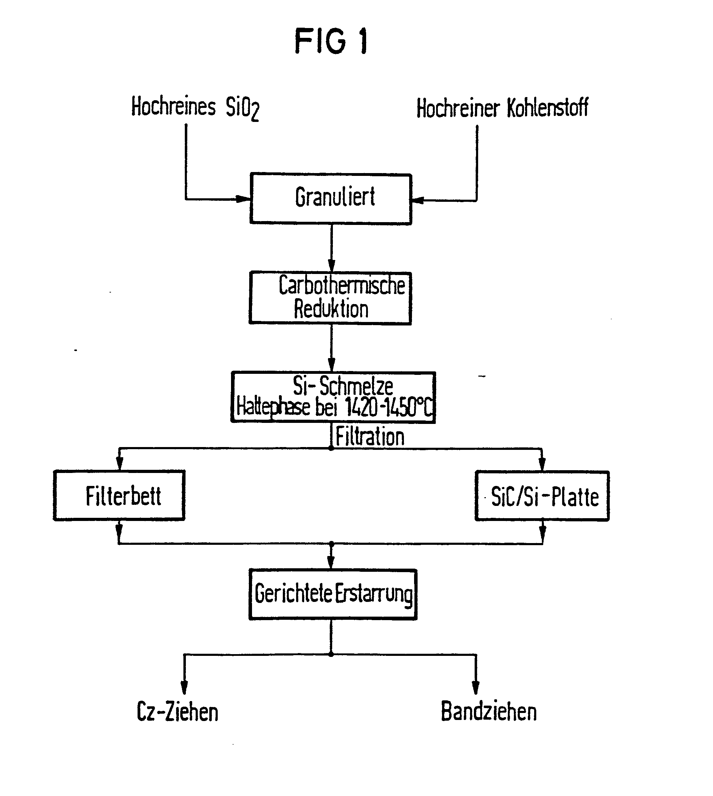

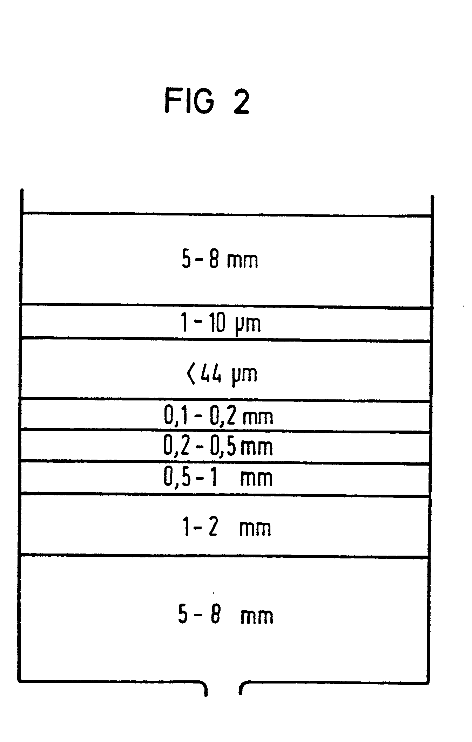

Nachfolgend wird die Erfindung anhand der Figuren 1 und 2 noch näher erläutert. Dabei zeigt

die Figur 1 in einem Flußdiagramm die Verfahrensfolge und

die Figur 2 den Schnitt durch ein Siliziumcarbid-Filterbett.

Figur 1: Hochreines $SiO_2$ und hochreiner Kohlenstoff werden als Granulat im Lichtbogenofen zu Silizium umgesetzt. Die Siliziumschmelze wird in beheizten Behältern aus hochreinem Graphit aufgefangen und anschließend längere Zeit bei einer Temperatur wenige Grad oberhalb des Schmelzpunktes (1420 bis 1450° C) gehalten. In dieser "Haltephase" sinken die SiC-Teilchen aufgrund des höheren spezifischen Gewichtes zum Boden des Behälters, während die leichten $SiO_2$-Teilchen auf der Schmelzoberfläche schwimmen. Die Haltephasentemperatur wird möglichst nahe am Siliziumschmelzpunkt eingestellt, um die Löslichkeit von SiC in der Schmelze zu verringern. Für die "Haltephase" beträgt die erforderliche Mindestzeit 30 Minuten bei einer Tiegelhöhe von ca. 15 cm. Sie verlängert sich mit wachsender Tiegelhöhe.

Ein weiteres Ziel der Haltephase ist die Umwandlung kleinster SiC-Schwebeteilchen in größere SiC-Kristalle, die dann leicht zu Boden sinken. Nach der Haltephase wird das schmelzflüssige Silizium durch eine beheizte Filterplatte aus dem Verbundwerkstoff SiC/Si geleitet. Die festen Teilchen (SiC, $SiO_2$) bleiben dabei auf der Filterplatte zurück. Zweckmäßigerweise geschieht die Filtration so, daß man den Boden eines hochreinen Graphittiegels durch eine dünne Platte aus SiC/Si ersetzt. Bei Temperaturen oberhalb des Schmelzpunktes von Silizium fließt das im Graphittiegel vorhandene Silizium aus und öffnet somit feinste "Kanäle". Untersuchungen haben gezeigt, daß der Hauptanteil der SiC-Teilchen eine Größe zwischen 3 und 10 μm besitzt. Für eine effektive Filtration sollte deshalb der Durchmesser der "Kanäle" in der SiC/Si-Platte

bei kleiner 3 μm liegen.

Figur 2: Alternativ zur Filtration durch eine aus einem SiC-Si-Verbundwerkstoff bestehende Platte kann auch ein Filterbett aus SiC-Körnern verwendet werden. Das Filterbett ist dabei so aufgebaut, daß die SiC-Korngröße in Flußrichtung der Siliziumschmelze von ca. 1 μm bis 8 mm zunimmt. Das Filterbett weist eine Deckschicht aus 5 bis 8 mm großen SiC-Körnern auf, die das Aufwirbeln von feinen Teilchen verhindern. Die Höhe des Filterbettes beträgt 30 bis 40 mm.

Nach der Filtration wird das Silizium in hochreinen Graphitkokillen aufgefangen und einer gerichteten Erstarrung unterworfen. Dieses Material kann anschließend durch einen Czochralski-Ziehprozeß in einkristalline Siliziumstäbe oder mit einem Bandziehverfahren in polykristalline Siliziumbänder übergeführt werden. In beiden Fällen erhält man Siliziumkörper, die nach ihrer Zerteilung zur Herstellung von Solarzellen mit einem Wirkungsgrad größer 10 % geeignet sind.

## Patentansprüche

1. Verfahren zum Abtrennen von festen Reaktionsprodukten, wie SiO$_2$ und SiC, aus im Lichtbogenofen bei der Reduktion von SiO$_2$ und Kohlenstoff erzeugtem schmelzflüssigem Silizium, welches vorzugsweise als Ausgangsmaterial zur Herstellung von Solarzellen verwendet wird, dadurch gekennzeichnet, daß das schmelzflüssige Silizium nach einer sogenannten "Haltephase" bei einer Temperatur im Bereich oberhalb des Schmelzpunktes von Silizium durch eine beheizte, aus dem Verbundwerkstoff SiC/Si bestehende Schicht filtriert, in hochreinen Graphitkokillen aufgefangen und einer gerichteten Erstarrung unterworfen wird.

2. Verfahren nach Anspruch 1, dadurch gekennzeichnet, daß für die Filtration ein Graphittiegel verwendet wird, dessen Boden aus einer Platte aus SiC/Si besteht.

3. Verfahren nach Anspruch 1 und/oder 2, dadurch gekennzeichnet, daß der Gehalt an SiC im SiC/Si-Verbundwerkstoff so eingestellt wird, daß bei der Filtration in der SiC/Si-Schicht bzw. Platte Kanäle mit einem Durchmesser kleiner 3 μm entstehen.

4. Verfahren nach einem der Ansprüche 1 bis 3, dadurch gekennzeichnet, daß anstelle der SiC/Si-Platte ein aus SiC-Körnern bestehendes Filterbett verwendet wird, wobei die SiC-Korngröße in Flußrichtung des schmelzflüssigen Siliziums zunimmt.

5. Verfahren nach Anspruch 4, dadurch gekennzeichnet, daß die oberste Schicht aus 1 - 10 μm SiC-Körnern und die unterste Schicht aus 5 - 8 mm SiC-Körnern besteht.

6. Verfahren nach einem der Ansprüche 1 bis 5, dadurch gekennzeichnet, daß die Temperatur der Haltephase auf 1425 bis 1450°C eingestellt wird.

7. Verfahren nach einem der Ansprüche 1 bis 6, dadurch gekennzeichnet, daß nach der gerichteten Erstarrung das kristalline Silizium einem Czochralski-Ziehprozeß zur Herstellung einkristalliner Siliziumstäbe unterworfen wird.

8. Verfahren nach einem der Ansprüche 1 bis 6, dadurch gekennzeichnet, daß nach der gerichteten Erstarrung das kristalline Silizium wieder aufgeschmolzen und durch ein Bandziehverfahren in polykristalline Siliziumbänder übergeführt wird.

## Revendications

1. Procédé de séparation de produits de réaction solides, comme SiO$_2$ et SiC, du silicium fondu, produit au four à arc, par la réduction de SiO$_2$ par du carbone, et utilisé de préférence comme matière première pour la fabrication de piles solaires, caractérisé en ce qu'il consiste à filtrer le silicium fondu, après ce que l'on appelle une "phase de maintien" à une température supérieure au point de fusion du silicium, à travers une couche chauffée en le matériau composite SiC/Si, à le recueillir dans des lingotières en graphite très pur, et à le soumettre à une solidification orientée.

2. Procédé suivant la revendication 1, caractérisé en ce qu'il consiste à utiliser, pour la filtration, un creuset en graphite dont le fond est constitué d'une plaque en SiC/Si.

3. Procédé suivant la revendication 1 et/ou 2, caractérisé en ce qu'il consiste à régler la teneur en SiC du matériau composite SiC/Si de manière à former, lors de la filtration, dans la couche de SiC/Si et dans la plaque, des canaux d'un diamètre inférieur à 3 microns.

4. Procédé suivant l'une des revendications 1 à 3, caractérisé en ce qu'il consiste à utiliser, au lieu de la plaque en SiC/Si, un lit filtrant constitué de grains de SiC, la granulométrie du SiC augmentant dans le sens d'écoulement du silicium fondu.

5. Procédé suivant la revendication 4, caractérisé en ce que la couche la plus élevée est constituée de grains de SiC de 1 à 10 microns, et la couche la plus basse de SiC de 5 à 8 mm.

6. Procédé suivant l'une des revendications 1 à 5, caractérisé en ce qu'il consiste à régler la température de la phase de maintien entre 1425 et 1450°C.

7. Procédé suivant l'une des revendications 1 à 6, caractérisé en ce qu'il consiste à soumettre, après la solidification orientée, le silicium cristallin à un processus de tirage de Czochralski pour préparer des barreaux de silicium monocristallins.

8. Procédé suivant l'une des revendications 1 à 6, caractérisé en ce qu'il consiste à refondre le silicium cristallin, après la solidification orientée, et à le transformer en bandes de silicium polycristallin par un procédé de tirage de bande.

## Claims

1. Method for separating solid reaction products, such as $SiO_2$ and SiC, from molten silicon which is produced in the electric arc furnace by the reduction of $SiO_2$ and carbon, which silicon is preferably used as starting material for the production of solar cells, characterised in that, after a so-called "holding phase", the molten silicon is filtered at a temperature in the range above the melting point of silicon through a heated layer consisting of the composite material SiC/Si, collected in high-purity graphite moulds and subjected to a directional solidification.

2. Method according to Claim 1, characterised in that a graphite crucible whose base consists of an SiC/Si plate is used for the filtration.

3. Method according to Claim 1 and/or Claim 2, characterised in that the content of SiC in the SiC/Si composite material is so adjusted that, during the filtration, channels with a diameter of less than 3 μm are produced.

4. Method according to one of the Claims 1 to 3, characterised in that instead of the SiC/Si plate, a filter bed consisting of SiC particles is used, the particle size increasing in the flow direction of the molten silicon.

5. Method according to Claim 4, characterised in that the uppermost layer consists of 1 - 10 μm SiC particles and the lowermost layer of 5 - 8 mm SiC particles.

6. Method according to one of the Claims 1 to 5, characterised in that the temperature of the holding phase is adjusted to 1425 to 1450° C.

7. Method according to one of the Claims 1 to 6, characterised in that, after the directional solidification, the crystalline silicon is subjected to a Czochralski drawing process to produce monocrystalline silicon rods.

8. Method according to one of the Claims 1 to 6, characterised in that after the directional solidification, the crystalline silicon is remelted and converted into polycrystalline silicon strips by a strip drawing process

# FIG 1

Hochreines SiO$_2$          Hochreiner Kohlenstoff

Granuliert

Carbothermische Reduktion

Si-Schmelze
Haltephase bei 1420-1450°C

Filtration

Filterbett          SiC/Si-Platte

Gerichtete Erstarrung

Cz-Ziehen          Bandziehen

# FIG 2

| |
|---|
| 5 - 8 mm |
| 1 - 10 µm |
| < 44 µm |
| 0,1 - 0,2 mm |
| 0,2 - 0,5 mm |
| 0,5 - 1 mm |
| 1 - 2 mm |
| 5 - 8 mm |